# EUROPEAN PATENT APPLICATION

(11) **EP 4 848 933 A1**
(43) Date of publication of application: **02.12.2026**
(21) Application number: 25179548.0
(22) Date of filing: 28.05.2025
(51) Int. Cl.: H10D 30/47, H10D 62/10, H10D 62/53, H10D 84/82, H10D 84/05, H10D 30/01, H10D 64/23, H10D 62/85

(54) **SEMICONDUCTOR DEVICE, GROUP III NITRIDE DIE AND METHOD OF FABRICATING A GROUP III NITRIDE DEVICE**

(71) Applicant: Infineon Technologies Austria AG, 9500 Villach (AT)
(72) Inventor: PRECHTL, Gerhard, 9232 Rosegg (AT)
(74) Representative: JENSEN & SON

(57) **Abstract**

A semiconductor device comprises an epitaxial crystalline Group III nitride body comprising a first major surface, a Group III nitride channel layer (13) and a Group III nitride barrier layer (14) arranged on the Group III nitride channel layer and forming a heterojunction therebetween capable of supporting a two-dimensional charge gas (16), a first power finger, a second power finger and a gate finger (19) located on the first major surface. The gate finger is located between the first and second power fingers. At least one first region (20) of the Group III nitride body that is located under the gate finger comprises a trap-rich crystal structure.

## Description

### BACKGROUND

To date, transistors used in power electronic applications have typically been fabricated with silicon (Si) semiconductor materials. Common transistor devices for power applications include Si CoolMOS^{®}, Si Power MOSFETs, and Si Insulated Gate Bipolar Transistors (IGBTs). More recently, silicon carbide (SiC) power devices have been considered. Group III-N semiconductor devices, such as gallium nitride (GaN) devices, are now emerging as attractive candidates to carry large currents, support high voltages and to provide very low on-resistance and fast switching times.

EP 3 605 810 A2 describes a circuit including two GaN transistors. The circuit may be used as a startup circuit for a switched-mode power supply (SMPS) converter. Such converters are widely used in various applications ranging from telecommunication equipment to automobiles, power chargers for portable electronic devices, among others.

It is desirable to provide a circuit with two or more Group III nitride-based devices formed in a common substrate.

### SUMMARY

In an embodiment, a semiconductor device is provided that comprises an epitaxial crystalline Group III nitride body comprising a first major surface, a Group III nitride channel layer and a Group III nitride barrier layer arranged on the Group III nitride channel layer and forming a heterojunction therebetween capable of supporting a two-dimensional charge gas, a first power finger, a second power finger and a gate finger located on the first major surface. The gate finger is located between the first and second power fingers. At least one first region of the Group III nitride body that is located under the gate finger comprises a trap-rich crystal structure.

In an embodiment, a Group III nitride die is provided that comprises at least one first transistor device according to any one of the embodiments described herein, or at least one bidirectional switch according to any one of the embodiments described herein, that is located in the Group III nitride body and a second transistor device that is located in the Group III nitride body. The second transistor device has a higher threshold voltage than a threshold voltage of the at least one first transistor device, or a higher threshold voltage than a threshold voltage of the at least one bidirectional switch.

In an embodiment, a method of fabricating a Group III nitride transistor device is provided. The method comprises providing an epitaxial crystalline Group III nitride body comprising a first major surface, a Group III nitride channel layer and a Group III nitride barrier layer arranged on the Group III nitride channel layer and forming a heterojunction therebetween capable of supporting a two-dimensional charge gas, implanting species into the Group III nitride body and forming at least one first region having a trap-rich crystal structure in the epitaxial crystalline Group III nitride body, or implanting species into the Group III nitride body and forming at least one first region having a trap rich crystal structure between an electrically inactive region and an epitaxial crystalline region and thus forming a transition region between the electrically inactive region and the epitaxial crystalline region, forming a gate finger on the first major surface that extends over the at least one first region and forming a first power finger and a second power finger on the first major surface on opposing sides of the gate finger.

Those skilled in the art will recognize additional features and advantages upon reading the following detailed description, and upon viewing the accompanying drawings.

### BRIEF DESCRIPTION

The elements of the drawings are not necessarily to scale relative to each other. Like reference numerals designate corresponding similar parts. The features of the various illustrated embodiments can be combined unless they exclude each other. Exemplary embodiments are depicted in the drawings and are detailed in the description which follows.
Figure 1 includes figures 1A to 1C and illustrates view of a semiconductor device.
Figure 2 illustrates a top view of a semiconductor device.
Figure 3 includes figures 3A to 3D and illustrates a method of fabricating a semiconductor device.
Figure 4 illustrates a top view of a portion of semiconductor device according to an embodiment.
Figure 5 illustrates a semiconductor device according to an embodiment.
Figure 6 illustrates a Group III nitride die which has first and second devices of differing threshold voltages.

### DETAILED DESCRIPTION

In the following detailed description, reference is made to the accompanying drawings, which form a part thereof, and in which is shown by way of illustration specific embodiments in which the invention may be practiced. In this regard, directional terminology, such as "top", "bottom", "front", "back", "leading", "trailing", etc., is used with reference to the orientation of the figure(s) being described. Because components of the embodiments can be positioned in a number of different orientations, the directional terminology is used for purposes of illustration and is in no way limiting. It is to be understood that other embodiments may be utilized and structural or logical changes may be made without departing from the scope of the present invention. The following detailed description, thereof, is not to be taken in a limiting sense, and the scope of the present invention is defined by the appended claims.

A number of exemplary embodiments will be explained below. In this case, identical structural features are identified by identical or similar reference symbols in the figures. In the context of the present description, "lateral" or "lateral direction" should be understood to mean a direction or extent that runs generally parallel to the lateral extent of a semiconductor material or semiconductor carrier. The lateral direction thus extends generally parallel to these surfaces or sides. In contrast thereto, the term "vertical" or "vertical direction" is understood to mean a direction that runs generally perpendicular to these surfaces or sides and thus to the lateral direction. The vertical direction therefore runs in the thickness direction of the semiconductor material or semiconductor carrier.

As employed in this specification, when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present.

As employed in this specification, when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

A depletion-mode device, such as a high-voltage depletion-mode transistor, has a negative threshold voltage which means that it can conduct current at zero gate voltage. These devices are normally on. An enhancement-mode device, such as a low-voltage enhancement-mode transistor, has a positive threshold voltage which means that it cannot conduct current at zero gate voltage and is normally off.

As used herein, the phrase "Group III-Nitride" refers to a compound semiconductor that includes nitrogen (N) and at least one Group III element, including aluminum (Al), gallium (Ga), indium (In), and boron (B), and including but not limited to any of its alloys, such as aluminum gallium nitride (AlₓGa₍₁₋ₓ₎N), indium gallium nitride (In_{y}Ga_{(1-y)}N), aluminum indium gallium nitride (AlₓIn_{y}Ga_{(1-x-y)}N), gallium arsenide phosphide nitride (GaAsₐP_{b}N_{(1-a-b)}), and aluminum indium gallium arsenide phosphide nitride (AlₓIn_{y}Ga_{(1-x-y)}AsₐP_{b}N_{(1-a-b)}), for example. Aluminum gallium nitride and AlGaN refers to an alloy described by the formula AlₓGa₍₁₋ₓ₎N, where 0 < x < 1.

As used herein, various device types and/or doped semiconductor regions may be identified as being of n type or p type, but this is merely for convenience of description and not intended to be limiting, and such identification may be replaced by the more general description of being of a "first conductivity type" or a "second, opposite conductivity type" where the first type may be either n or p type and the second type then is either p or n type.

The figures illustrate relative doping concentrations by indicating "-" or "+" next to the doping type "n" or "p". For example, "n⁻" means a doping concentration which is lower than the doping concentration of an "n"-doping region while an "n⁺"-doping region has a higher doping concentration than an "n"-doping region. Doping regions of the same relative doping concentration do not necessarily have the same absolute doping concentration. For example, two different "n"-doping regions may have the same or different absolute doping concentrations.

One design parameter of Group III nitride transistor devices, such as High Electron Mobility Transistor (HEMT) devices including p-GaN Schottky gate HEMTs, is the threshold voltage, Vth. The value of the threshold voltage, Vth, can be selected by selecting a suitable AlGaN barrier design in combination with the pGaN gate properties, for example. In power transistor devices with integrated driver logic, it would be beneficial to have Group III nitride HEMT transistors with different threshold voltages integrated within a common Group III nitride substrate, e.g. die.

The power transistor should have a higher Vth than the gate driver or logic transistors so that during power ON, the logic transistors with the lower Vth can work earlier than the power transistor. With this difference in the threshold voltage between the control logic transistor and the power HEMT, an uncontrolled turn on of the power HEMT can be avoided.

However, due to the fact that the threshold of the Group III nitride HEMT transistor is determined by the Group III nitride barrier properties, producing transistors with different threshold voltages on the same die is challenging.

The present disclosure proposes to use damage implantation, e.g. a N implant or a Ar implant, to fabricate a transistor with a lower Vth.

In an embodiment, a region of the Group III nitride of the transistor device is implanted with a small amount of damage to the epitaxial crystal structure. This small amount of damage provides a Group III nitride transistor device that has a lower threshold voltage than a transistor device formed of the epitaxial Group III nitride. This effect of damage to the epitaxial crystalline structure can be used to adjust the threshold voltage of a transistor device or regions of a transistor device. The amount of damage which results in the lower threshold voltage for a transistor device is less than the damage used in the edge region which results in electrical insulation. The Group III nitride region at the periphery of the device is electrically inactive. Alternatively, the entire area of the Group III nitride of the transistor device is implanted with a small amount of damage to the epitaxial crystal structure. This small amount of damage provides a Group III nitride transistor device that has a lower threshold voltage than a transistor device formed of the epitaxial Group III nitride. A higher dose may be implanted into the edge region so that the edge region is electrically inactive and/or electrically insulating. One mask may be used for implanting the edge region only and one mask may be used to implant the area of the Group III nitride transistor device to form the transistor device with the lower threshold voltage.

In some embodiments, ion scattering during the implantation in the edge region causes ions to be scattered into adjacent portions of the active region leading to the formation of deep traps. These deep traps are still not present in sufficient amounts to make this region inactive but provide an effective doping, which alters the threshold voltage in this region of the device. Since it is possible to locally implant a discrete area of a substrate, e.g. using a mask, this allows different regions of a substrate to be selectively implanted so as to achieve a lower threshold voltage in this implanted region compared to that of the non-implanted, e.g. masked, regions.

Thus, devices having different threshold voltages can be formed in a common substrate. There is no need to locally adjust the properties, e.g. thickness and/or composition, of the Group III nitride barrier layer in order to adjust the threshold voltage of a device formed in this localized region. Thus, devices having different threshold voltages can be formed in a common substrate more easily.

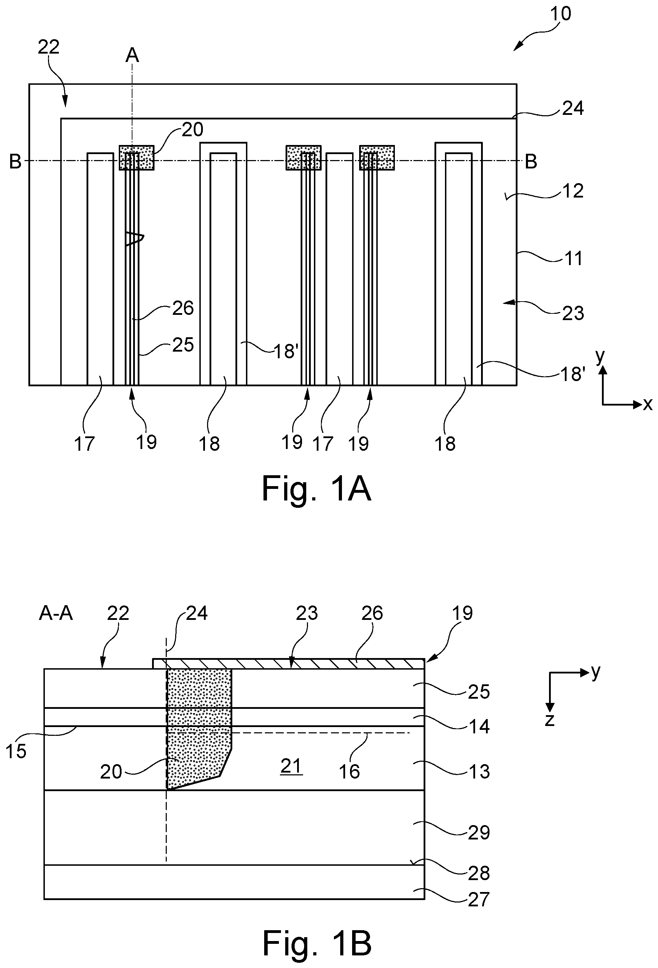

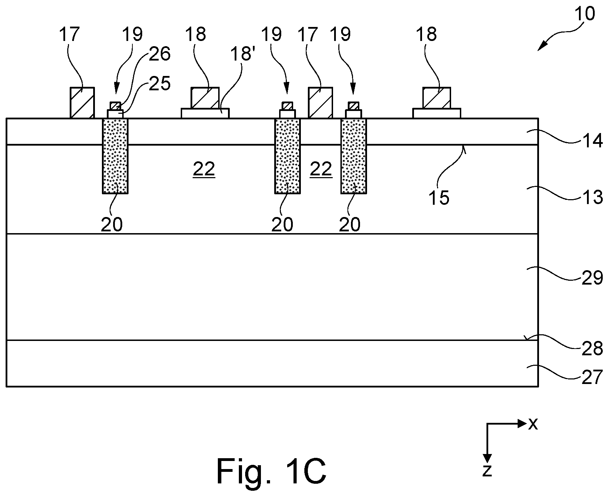

Figure 1 includes figures 1A to 1C and illustrates views of a semiconductor device 10. Figure 1A illustrates a top view of a portion of the semiconductor device 10, figure 1B a cross-sectional view of the semiconductor device 10 along the line A-A shown in figure 1A and figure 1C a cross-sectional view of the semiconductor device 10 along line B-B shown in figure 1A.

The semiconductor device 10 comprises a Group III nitride body 11 which has a first major surface 12. Referring to the cross-sectional view of figure 1B, the Group III nitride body 11 comprises a Group III nitride channel layer 13 and a Group III nitride barrier layer 14 which is arranged on the Group III nitride channel layer 13. A heterojunction 15 is formed between the Group III nitride channel layer 13 and the Group III nitride barrier layer 14 which is capable of supporting a two-dimensional charge gas. The two-dimensional charge gas is indicated schematically in the drawings by the dotted line 16. The two-dimensional charge gas may be a two-dimensional electron gas (2DEG) or two-dimensional hole gas (2DHG). The semiconductor device 10 may be an enhancement mode device which is normally off. In this case, the schematically illustrated two-dimensional charge gas 16 is only available if the gate is turned on, i.e. when a gate voltage larger than the threshold voltage is applied.

Since a heterojunction 15 is formed between the Group III nitride channel layer 13 and the Group III nitride barrier layer 14, the Group III nitride channel layer 13 and the Group III nitride barrier layer 14 have different compositions and different bandgaps. In an embodiment, the Group III nitride channel layer 13 comprises gallium nitride (GaN) and the Group III nitride barrier layer 14 comprises aluminium gallium nitride (AlₓGa₍₁₋ₓ₎N, where 0 < x < 1).

The Group III nitride body 11 including the Group III nitride channel layer 13 and the Group III nitride barrier layer 14 are epitaxial crystalline layers which have been grown by epitaxial deposition on a base substrate 27.

A first power finger 17, a second power finger 18 and a gate finger 19 are located on the first major surface 12 of the Group III nitride body 11, which is provided by the surface of the Group III nitride barrier layer 14. The first power finger 17, the second power finger 18 and the gate finger 19 each have an elongate stripe-like structure and extend substantially parallel to one another. The gate finger 19 is arranged between the first power finger 17 and the second power finger 18.

The first major surface 12 of the Group III nitride body 11 lies in the X-Y plane and the thickness of the Group III nitride body lies in the Z direction. The first and second power fingers 17, 18 and the gate finger 19 have a length that extends in the Y direction. The first and second power fingers 17, 18 and the gate finger 19 are spaced apart from one another in the X direction and extend substantially parallel to one another in the Y direction. The term "laterally" is used herein to denote a direction in the X-Y plane.

In some embodiments, the semiconductor device 10 provides a transistor device so that the first power finger 17 provides a source finger and the second power finger provides a drain finger. The transistor device may be a HEMT (High Electron Mobility Transistor). In some embodiments, see figures 1A and 1C for example, the transistor device includes a plurality of transistor cells each including a source finger, gate finger and drain finger in which the source and drain fingers are common to adjacent cells such that a pattern of source gate drain gate source gate drain is provided.

In an alternative embodiment, the semiconductor device 10 provides a bidirectional switch so that each of the first and second power fingers 17, 18 provide an input/output finger.

Figure 1B illustrates a cross-sectional view along the length of the gate finger 19. Referring to the cross-sectional view of Figure 1B, the Group III nitride body 11 comprises at least one first region 20 which comprises a trap-rich crystal structure.

The at least one first region 20 is located in the Group III nitride body 11 under the gate finger 19. The first region 20 comprises a greater number of traps than second portions 21 of the epitaxial Group III nitride body 11 which are located adjacent to the one first region 20, for example the portion of the Group III nitride body 11 which is located under the first and second power fingers 17, 18, as can be seen in Figure 1C. The trap-rich first region 20 is distinguishable from the epitaxial crystalline structure of the second region 21 by the higher concentration of the lattice defects or dopants or traps in the first region 20. The higher concentration of lattice defects can be detected using etching and scanning electron microscopy, for example, as etch rate is different. The charging during scanning electron microscopy also differs so that contrast can be seen in the micrograph even after delayering of the device thus distinguishing between areas of differing lattice defect or trap concentrations.

In some embodiments, the first region 20 adjoins and forms an interface with the second region 21. The second region 21 can be considered to be contiguous with the first region 20.

The trap-rich crystal structure of the first region 20 may be provided by different structures. In an embodiment, the trap-rich crystal structure comprises a disturbed crystal structure. The disturbed crystal structure comprises at least one of the group consisting of vacancies, interstitial nitrogen atoms and interstitial Group III element atoms. In another embodiment, the trap-rich crystal structure is provided by dopants of a second conductivity type that opposes the first conductivity type of the Group III nitride body 11. In this embodiment, the trap-rich crystal structure of the first region 20 can be considered to be counter doped. In another embodiment, the trap-rich crystal structure is provided by dopants of a first conductivity type and therefore of the same type as the first conductivity type of the Group III nitride body 11. In this embodiment, the trap-rich crystal structure of the first region 20 is more highly doped than the epitaxial crystalline structure. The Group III nitride body 11 is intrinsically doped and n-type or p-type. This intrinsic doping may also be referred to as unintentionally doped. In another embodiment, the first region 20 comprises dopants of the same conductivity type as the conductivity type of the Group III nitride body 11 but comprises a different doping level. For example, the doping concentration of the dopants of the first conductivity type in the first region 20 may be less than or greater than the doping concentration of the dopants in the adjacent portion of the Group III nitride body 11.

The first region 20 of the semiconductor device 10 provides a region of the semiconductor device 10 that comprises a lower threshold voltage than the threshold voltage of an adjoining second region 21 of the semiconductor device.

Referring to figure 1A, the semiconductor device 10 comprises an edge region 22 which laterally surrounds an active region 23. The active region 23 is the region of the semiconductor device 10 which contributes to switching of the transistor device or bidirectional switch, whereas the edge region 22 does not contribute to switching of the transistor device or bidirectional switch. The edge region 22 is electrically inactive under normal operating conditions of the semiconductor device 10 and may comprise, a non-crystalline structure, for example, and/or is electrically inactive due to damage of the crystal structure, through deep traps, etc., the number of traps being higher than in the trap-rich first region 20. The edge region 22 is distinguishable from the trap-rich first region 20 and the epitaxial crystalline second region 21.

In some embodiments, the first region 20 is located in a transition region which is formed between the active region 23 and the edge region 22. The nominal position of the transition between the active region 23 and the edge region 22 is indicated in the drawings with the dotted line 24. In some embodiments, the first region 20 may extend into the contiguous regions of the edge region 22 and into the active region 23 from the nominal transition 24. In other embodiments, the first region 20 may be positioned only in the active area 23 and may extend from the transition 24 into the active area 23.

In the embodiment illustrated in figure 1, the gate finger 19 comprises a p-doped Group III nitride finger 25, which is arranged on the first major surface 12 of the Group III nitride barrier layer 14 of the Group III nitride body 11, and a metal finger 26 which is arranged on the p-doped Group III nitride finger 25. The p-doped Group III nitride finger 25 may be formed of p-doped GaN, e.g. Mg-doped GaN. The gate 19 including the p doped Group III nitride finger 25 and gate metal 26 provides a structure for an enhancement mode device, which is normally off. In other embodiments, the gate finger 19 may include a gate recess which is formed in the Group III nitride barrier layer 14 so as to provide an enhancement mode device. In other embodiments, the gate finger 19 is formed of a metal gate finger that is located on the Group III nitride barrier layer so as to provide a depletion mode device which is normally on. In other embodiments, the gate finger 19 comprises a gate dielectric that is located on the Group III nitride barrier layer and a metal gate finger that is located on the gate dielectric to provide a MIS HEMT.

In some embodiments, the gate metal finger 26 comprises a Schottky metal. A Schottky metal may be one or more of TiN, Ti, W, WSiₓ, Ta, TaN, Ni, Pd, Pt and Ir.

In some embodiments, the first and second power fingers 17, 18 are formed of an ohmic metal. In an embodiment, the first and second power fingers 17, 18 have a multilayer structure, for example Ti, Al and a capping metal such as TiN.

Figure 1B illustrates a cross-sectional view of the semiconductor device 10 along the length of one of the gate fingers 19 which extends from the active region 23 into the edge region 22. In figures 1B and 1C, it can be seen that the first region 20 extends through the p-doped Group III nitride gate finger 25, the first major surface 12 and the Group III nitride barrier layer 14 and into the Group III nitride channel layer 13. The first region 20, therefore, extends through and beyond the heterojunction 15 and the two-dimensional charge gas. In the cross-sectional view of figure 1B, it can also be seen that the first region 20 with the t(r)ap-rich crystal structure is formed between the edge region 22 and the adjoining second region 21 of the semiconductor device 10 which comprises an epitaxial crystalline layer which has a fewer number of traps than the first region 20.

The first region 20 has a width in the X direction that is greater than the width of the gate finger 19 but which does not extend to the first power finger 17 or the second power finger 18. A second portion 21 is, therefore, arranged between the first portion 20 and the first and second power fingers 17, 18 as can be seen in the cross-sectional view along the line B-B shown in figure 1C. The first region 20 has a length in the Y direction so that it is located under the end region of the gate finger 19 only.

The remainder of the gate finger 19 is located on a second region 21, as can be seen in the cross-sectional view of figure 1B. In other non-illustrated embodiments, the first region 20 has a width in the X direction that is greater than the width of the gate finger 19 and which extends to the first power finger 17 or the second power finger 18.

Both the first region 20 and the second section 21 contribute to the switching of the device and provide part of the active region 23. The first region 20 provides a switch, e.g. a transistor device or a bidirectional switch, that has a lower threshold voltage than the second region 21.

In some embodiments, see for example figures 1A and 1C, the drain finger 18 comprises a p-doped Group **III** nitride finger 18' that is in electrical contact with the metal drain finger.

Referring to the cross-sectional views of figures 1B and 1C, the Group III nitride body 11 may be formed by epitaxial deposition on a base substrate 27. The base substrate 27 has a growth surface 28 which is capable of supporting the epitaxial growth of one or more Group III nitride layers. A buffer structure 29 may be located on the growth surface 28 and the Group III nitride body 11 is located on the buffer structure 29 so that the Group III nitride channel layer 13 is located on the buffer structure 29 and the Group III nitride barrier layer 14 is located on the Group III nitride channel layer 13.

In some embodiments, the base substrate 27 is a foreign substrate, i.e. is formed of a material other than Group III nitride materials that includes the upper or growth surface 28 which is capable of supporting the epitaxial growth of one or more Group III nitride-based layers. The base substrate 27 may be formed of silicon and may be formed of monocrystalline silicon or an epitaxial silicon layer, for example, or sapphire, or SiC.

In some non-illustrated embodiments, the buffer structure 29 may further include a back barrier layer. The Group III nitride channel layer 13 is formed on the back barrier layer and forms a heterojunction with the back barrier layer and the Group III nitride barrier layer 14 is formed on the Group III nitride channel layer 13. The back barrier layer has a different bandgap to the channel layer and may comprise AlGaN, for example. The composition of the AlGaN of the back barrier layer may differ from the composition of the AlGaN used for the barrier layer 14.

A typical transition or buffer structure for a silicon substrate includes a AIN starting layer, which may have a thickness of several 100nm, on the silicon substrate followed by a AlₓGa₍₁₋ₓ₎N layer sequence, the thickness again being several 100nm's for each layer, whereby the Al content of about 50-75% is decreased down to 10-25% before the Group III nitride channel layer 13, e.g. GaN layer, or AlGaN back barrier, if present, is grown. Alternatively, a superlattice buffer can be used. Again, an AIN starting layer on the silicon substrate is used. Depending on the chosen superlattice, a sequence of AIN and AlₓGa₍₁₋ₓ₎N pairs is grown, where the thickness of the AIN layer and AlₓGa₍₁₋ₓ₎N is in the range of 2-25nm. Depending on the desired breakdown voltage the superlattice may include between 20 and 100 pairs. Alternatively, an AlₓGa₍₁₋ₓ₎N layer sequence as described above can be used in combination with the above mentioned superlattice.

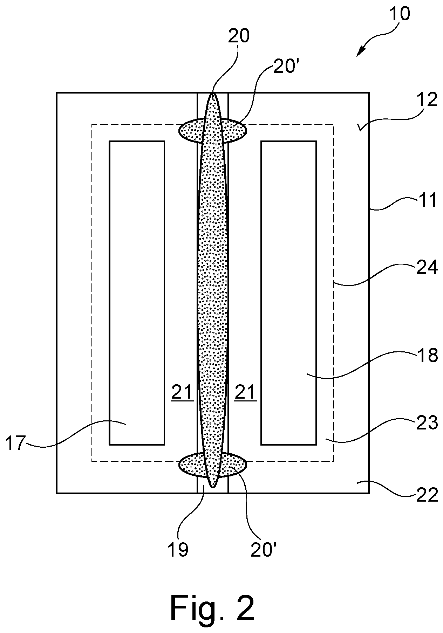

Figure 2 illustrates a semiconductor device 10 according to another embodiment. The semiconductor device 10 of this embodiment differs from the embodiment illustrated in figure 1 by the position of the first area 20 which has a trap-rich crystal structure. In this embodiment, the first area 20 is located under the gate finger 19 intermediate the length of the gate finger 19 and at a position which is laterally between and intermediate the length of the first power finger 17 and the second power finger 18. The first region 20 has a width so that it is spaced apart from the first power finger 17 and the second power finger 18 by a portion of the Group III nitride body 11 which has an epitaxial crystalline structure, but has a longer length in the Y direction compared to the embodiment illustrated in figure 1.

The first region 20 may have a longer length in the Y direction compared to the embodiment illustrated in figure 1. In some embodiments, the first region 20 extends along the entire length of the gate finger 19. In some embodiments, the first region 20 extends along the majority of, or even the entire length of, the portion of the gate finger 19, which is positioned in the active area 23 of the semiconductor device 10. The lateral area of the first region 20 may be at most, or the same as the lateral area of the gate finger 19 in the active area 23. In some embodiments, the width of the first area 20 is no greater than the width of the gate finger 19 at positions which are located laterally between the first and second power fingers 17, 18. A further first region 20' may be positioned at the transition 24 between the edge region 22 and the active region 23. The further first region 20' is also located under the gate finger 19 and has a width which extends beyond the width of the gate finger 19. A second region 21 with an epitaxial crystalline structure is located between the first region 20 with the trap-rich crystalline structure and the first power finger 17 and between the first region 20 with the trap-rich crystalline structure and the second power finger 18.

The semiconductor device 10 of the embodiments described with reference to figure 2 may be used to provide a switch, e.g. a transistor device or a bidirectional switch, that has a lower threshold voltage and may be used in applications in which devices of different threshold voltage are located in a common Group-III nitride-based substrate.

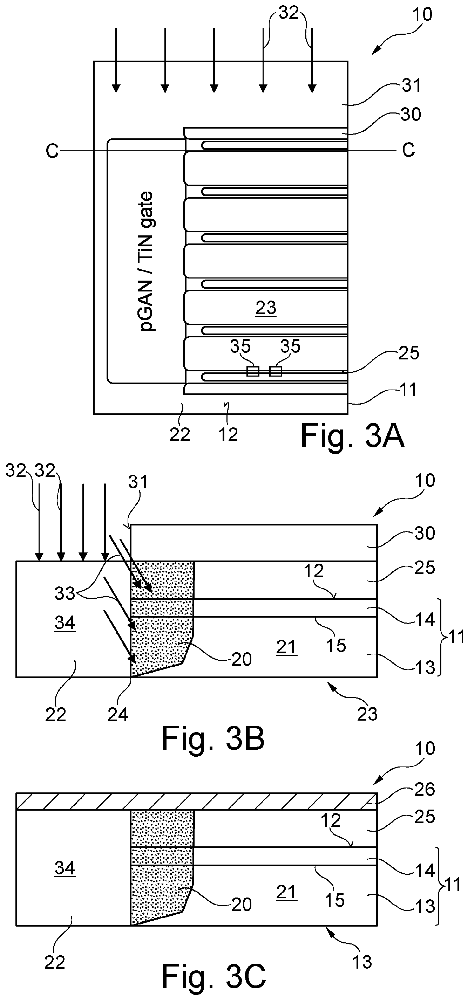

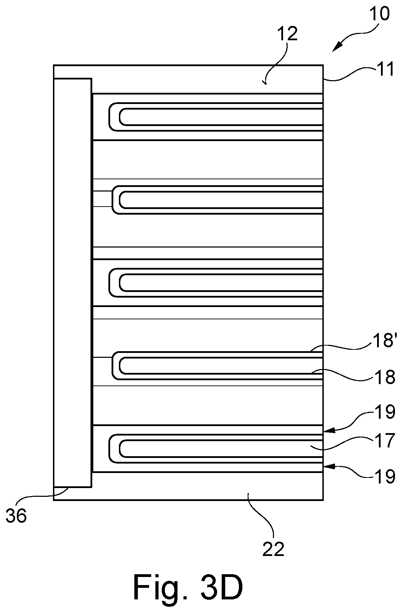

Figure 3, which includes figures 3A to 3D, illustrates a method for fabricating a semiconductor device 10. This method may be used for fabricating the semiconductor device 10 illustrated in figures 1 and 2.

Figure 3A illustrates a top view of the semiconductor device with a mask 30 on the first major surface 12 of the Group III nitride body 11. Figures 3B and 3C illustrate views cross-sectional views of along the length of the gate finger 19 along the line C-C shown in the top view figure 3A and figure 3D illustrates a top view of the semiconductor device after deposition of the gate metal finger 26 and first and second power fingers 17, 18.

The Group III nitride body 11 may be fabricated by first epitaxially depositing a Group III nitride channel 13 layer, for example an epitaxial GaN layer, and then depositing an epitaxially depositing a Group III nitride barrier layer 14 on the Group III nitride channel layer 13. The Group III nitride barrier layer 14 may comprise aluminium gallium nitride (AlₓGa₍₁₋ₓ₎N, where 0 < x < 1). The Group III nitride body 11 may be formed on a buffer structure 29 that is epitaxially grown on the growth surface 28 of a base substrate 27, which are not illustrated in figure 3. The base substrate 27 may be formed of monocrystalline silicon for example.

Referring to figure 3A, the method may then continue by forming the p-doped Group III nitride finger 25 of the gate 19. As shown in figure 3A, a plurality of p-doped Group III nitride fingers 25 which extend substantially parallel to one another may be deposited on the first major surface 12 of the group III nitride barrier layer 14. In some embodiments, pairs of p-doped Group III nitride fingers 25 are joined at one distal end or both distal ends by a respective connection section formed of the p-doped Group III nitride. In some embodiments, the p-doped Group III nitride regions 18' for the drain finger are deposited.

A mask 30 is then deposited which covers the active area 23 of the semiconductor device 10 and which has an opening 31 which exposes the edge region 22 from the mask 30. An implantation process into this exposed edge region 22 is carried out as is schematically indicated by the arrows 32 in figure 3B. The species, which are implanted, may comprise ions or atoms of one or more of the group consisting of N, Si, Ar, BF2, B, As and P.

During this implantation process, species are implanted into the first major surface 12 of the Group III nitride body 11 so as to form an edge region 22 having a non-crystalline crystal structure or a region with a very high deep trap density caused by implantation leading to an electrical inactive region. The trap density of the edge region 22 is higher than the trap-rich first region 20 and is distinguishable from a trap-rich region 20. This non-crystalline or electrically inactive structure extends into the first major surface 12 by a certain depth and is distinguishable from the epitaxial crystalline structure of the remainder of the Group III nitride body 11. Species are implanted into the adjoining portion 20 of the Group III nitride body 11, as is schematically indicated in figure 3B by the arrows 33. This adjoining portion 20 may be located directly under the mask 30 which covers the active region 23. These species are implanted into the p-doped Group III nitride gate finger 25, the Group III nitride barrier layer 14 and the Group III nitride channel layer as shown by the arrows 33. This implantation of the species forms the first region 20 which has changed the electrical properties of the structure due to the presence of deep traps. The first region 20 may have a disturbed crystalline structure and a greater number of traps than the adjoining epitaxial crystalline regions 21 of the Group III nitride body 11 and p-doped Group III nitride finger 25 which are positioned under the mask 30. The first region 20 may have a depth such that it extends through the p-doped Group III nitride gate finger 25, the Group III nitride barrier layer 14 and into the Group III nitride channel layer 13. The first region 20 provides a transition between the non-crystalline or electrically inactive edge region 22 and the epitaxial crystalline regions 21 of the active area 23 of the semiconductor device 10. In contrast to the electrically inactive edge region 22, the first region 20 contributes to switching in the final device structure. The threshold voltage provided by the disturbed first region 20 is however less than the threshold voltage provided by the epitaxial crystalline region 21. As used herein, the term "electrically inactive" means inactive in normal operation of the device.

In some embodiments, during the implantation process to form the edge region 22, as schematically indicated with the arrows 32, species may be implanted or scattered during the implantation, also known as lateral straggle into the adjoining portion 20 of the Group III nitride body 11, as is schematically indicated in figure 3B by the arrows 33, to form the disturbed structure in the first region 20. In other embodiments, the first region 20 is formed by a separate implantation process. For example, the mask 30 may be structured to form openings corresponding to the desired position of the first regions and the species implanted into the opening with an energy that is suitable for producing the trap-rich disturbed crystalline structure in the first regions 20.

In embodiments in which the gate finger 19 comprises a p doped Group III nitride finger 25, the species may also be implanted into the p doped Group III nitride finger 25 so that a trap-rich crystal structure is formed in the p doped Group III nitride finger in addition to the Group III nitride barrier layer 14 and Group III nitride channel layer 13 of the Group III nitride body 11. The gate metal layer 26 is then formed on the p doped Group III nitride finger 25.

Referring to figure 3C, afterwards, the mask 30 is removed and the gate metal 26 is deposited onto the p-doped Group III nitride fingers 25 in both the crystalline region 21 and implanted disturbed crystalline region 20 of the active area 23. The gate metal may be a Schottky metal. The gate metal 26 is then structured to form one gate metal finger 26 on each of the p-doped Group III nitride fingers 25.

Referring to figure 3D, the first power finger 17 and the second power finger 18 are then formed on the first major surface 12 of the Group III nitride body 11 on opposing sides of the gate finger 19 by, for example, depositing two metal fingers. In some embodiments, the gate metal 26 further extends into the edge region 22 where it may extend between a plurality of the gate metal fingers 26 and form a gate bus 36.

In some embodiments, the gate finger 19 is fabricated by first depositing a p doped Group III nitride layer, into which the species are implanted to form the trap-rich crystal structure of the first region 20. Then the p doped Group III nitride layer is structured to form at least one p doped Group III nitride finger 25. Commonly, a plurality of p doped Group III nitride fingers 25 are formed from the p doped Group III nitride layer, the p doped Group III nitride fingers extending parallel to one another. The gate metal fingers 26 are then formed on the respective p doped Group III nitride finger to form the gate finger 19. The first and second power fingers 17, 18 are than fabricated on opposing sides of the gate fingers 19 so as to form a source gate drain gate source gate pattern.

The gate metal finger 26 may be fabricated by forming a gate metal layer and then structuring the gate metal layer to form individual gate metal fingers 26 which are located on the respective ones of the plurality of doped Group III nitride fingers 25.

In embodiments of the semiconductor device comprising the third regions 34, which, for example are located intermediate the length of the gate finger 19, and optionally also intermediate the length of the first and second power fingers 17, 18, the third regions 34 and the edge region 22 are electrically inactive and have a higher trap density than the first regions 20. These electrically inactive regions may be formed from the epitaxial crystalline structure of the Group III nitride body 11 by appropriate selection of the implantation conditions e.g. energy, and species. The third regions 34 may be exposed by suitable structuring of the mask 30 to include openings 35, seen in the top view of figure 3A, and the species is implanted into the openings 35 in the mask 30.

The first regions 20 may be formed at the same time as the third regions 34. Some of these species implanted into the openings 35 above the third regions 34 are scattered in lateral directions underneath the nominally covered and masked areas to introduce defects and form the first region 20 with the disturbed trap-rich crystal structure under nominally masked areas. Further laterally away from the openings 35, the epitaxial crystalline structure of the Group III nitride body 11 is retained since the species or a quantity of the species that is sufficient to form a larger number of traps does not extend into these regions 21. Consequently, the first region 20 with the trap-rich structure is contiguous to the third region 34and contiguous with the second region 21 having an epitaxially crystalline structure. The third region 34 is electrically inactive and may have a non-crystalline structure or an electrically isolated structure due to the presence of deep traps and has a higher trap density than the first region 20. In some embodiments the implantation is carried out such that, when the species are implanted into the openings 35 and into the third region 34, the first regions 20 are formed contemporaneously with the third regions 34. In some embodiments, the implantation process used to form the edge region 22 is also used to form the third regions 34 so that both the third region 34 and edge region 22 are formed contemporaneously with the first region 20.

In some embodiments, the first regions 20 can be formed by a separate implantation process using conditions adjusted to form a trap-rich crystal structure rather than am electrically inactive region, e.g. a non-crystalline structure or a higher trap density structure, from the epitaxial crystalline structure of the Group III nitride body 11. For example, an appropriate dose and/or energy may be used for implanting the species. This energy and/or dose may be lower than the energy or dose, respectively, of the species used to implant the species into the edge region 22 and, if present, the third regions 34 to form the electrically inactive region.

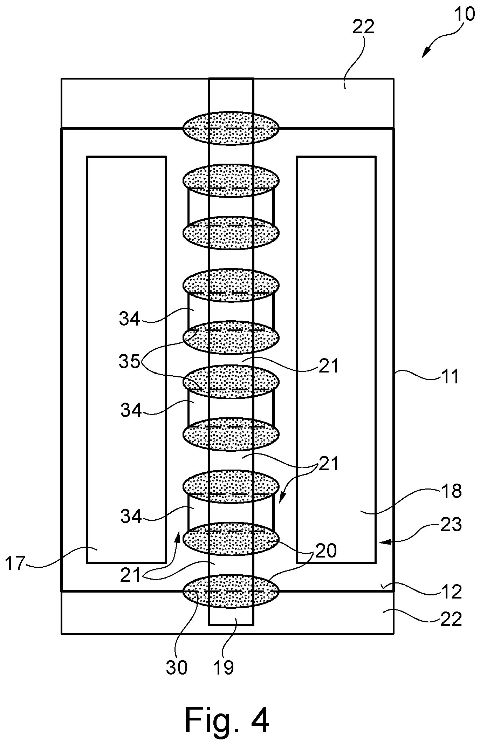

Figure 4 illustrates a top view of a portion of semiconductor device 10 according to another embodiment.

As in the semiconductor devices 10 described with reference to figures 1 to 3, the semiconductor device 10 illustrated in and described with reference to figure 4 includes a first power finger 17, a second power finger 18 and a gate finger 19 which is positioned laterally between the first power finger 17 and the second power finger 18. The first and second power fingers 17, 18 and the gate finger 19 are positioned on the first major surface 12 of the Group III nitride body 11 in the active area 23 of the device. The active area 23 is surrounded by an edge region 22, of which only two opposing sections can be seen in figure 4. The edge region 22 is electrically inactive during normal operating conditions of the semiconductor device 10. The edge region 22 may have a crystalline structure, which is sufficiently disturbed such that the crystal is electrically isolating, for example due to damage of the crystal structure, through deep traps, etc. In contrast, the active area 23 has an epitaxial crystalline structure. In this embodiment, a plurality of separate channel regions is formed along the length of the gate finger 19 by forming a plurality of third regions 34 which are electrically inactive, for example due to damage of the crystal structure, through deep traps, etc in these regions. The third regions 34 are arranged in a column extending in a longitudinal or Y-direction using the Cartesian coordinate system. These third regions 34 are spaced apart by second regions 21 which have an epitaxially crystalline structure. Alternate electrically inactive regions 34 and epitaxial crystalline regions 21 are arranged in the Y-direction.

In an embodiment, the electrically inactive regions 34 have a width which is less than the spacing between the first and second power fingers 17, 18 so that the electrically inactive regions 34 are spaced apart from both the first and second power fingers 17, 18 by a portion of the epitaxial crystalline region 21 of the Group III nitride body 11. The first and second power fingers 17, 18 are located on the epitaxial crystalline material 21.

First regions 20 having a trap-rich, disturbed crystalline structure are formed at the transition between the third regions 34 and the second regions 21. This trap-rich crystalline structure may be formed by implanting species into a plurality of discrete regions of the epitaxial crystalline structure of the Group III nitride body 11 so as to disrupt this crystalline structure. The first regions 20 are arranged in a column which extends in the Y direction and are spaced apart from one another by either an electrically inactive third region 34 or an epitaxial crystalline second region 21. In the Y direction, an arrangement of first region 20, third region 34. first region 20, second region 21, first region 20, third region 34, first region 20, second region 21 is formed.

The third regions 34 may be fabricated by implanting species into regions of the first major surface 12 of the epitaxial crystalline Group III nitride body 11 which are exposed in openings 35 of a mask 30 that is formed on the Group III nitride body 11. Lateral scattering of the implanted species under the mask 30 may be used to forms the first regions 20 at the edge of the third regions 34. Thus, in the long direction of the gate finger 19, i.e. in the Y direction, an arrangement of first region 20, third region 34. first region 20, second region 21, first region 20, third region 34, first region 20, second region 21 is formed. A gate finger 19 may extend over this structure continuously so that first switching sections having a lower threshold voltage are formed by the first regions 20 having a disturbed crystal structure and second switching sections having a higher threshold voltage are formed by the second regions 21 having an epitaxial crystal structure. These sections of lower and higher threshold voltage are coupled in parallel between the first and second power fingers 17, 18, since the first and second power fingers 17, 18 and the gate finger 19 are electrically connected to the two-dimensional charge gas formed in both the first and second regions 20, 21.

The second regions 21 form a channel region of a transistor device structure between the first and second power fingers 17, 18 and the gate finger 19 which has a first threshold voltage. The first regions 20 form a channel region of a transistor device structure between the first and second power fingers 17, 18 and the gate finger 19 which has a second threshold voltage which is less than the first threshold voltage due to the increased number of traps in the disturbed structure of the first region 20 compared to the number of traps present in the second region 21 with the epitaxial crystalline structure. The third regions 34 are electrically inactive and have a higher number of traps than the first region 20. Thus, a plurality of transistor device structures is formed which are connected in parallel between the common first and second power fingers 17, 18 and the common continuous gate 19.

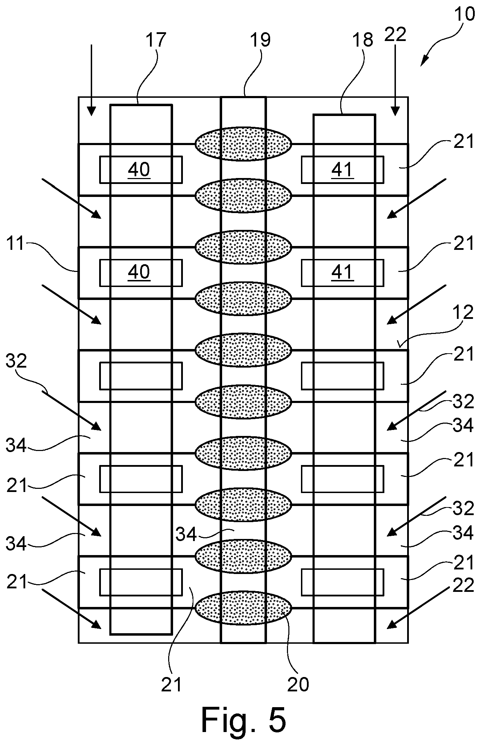

Figure 5 illustrates a semiconductor device 10 according to another embodiment. The semiconductor device 10 illustrated in and described with reference to figure 5, comprises a plurality of transistor device structures are coupled in parallel.

A structure comprising alternate third regions 34 with an electrically inactive or isolated structure and second regions 21 with an epitaxial crystalline structure are arranged in a column extending in the Y direction. A first region 20 with a disturbed crystal structure is formed at the interface between the third regions 34 which are electrically inactive and second regions 21 which comprise an epitaxial crystal line structure. The width of the third region 34 is greater than in the embodiment illustrated in figure 4. The width of the third region 34 in the X direction is greater than the distance between the first and second power fingers 17, 18. In an embodiment, the width of the third regions 34 correspond to the width of the device or the width of the Group III nitride body 11. In another embodiment, the first region 20 extends along the whole side.

The semiconductor device 10 comprises a plurality of crystalline epitaxial second regions 21 which are interleaved with electrically inactive third regions 34. These alternative epitaxial regions 21 and electrically inactive regions 34 are arranged in a column in the Y direction. A first region 20 is formed at the interface between the third regions 34 and the second regions 21 so that a plurality of discrete first regions 20 with a trap-rich structure are formed at intervals along the length of the gate electrode 19 and are arranged in a column in the Y direction. An arrangement of third region 34, first region 20, second region 21, first region 20, third region 34 is formed.

In this embodiment, the first power finger 17 is divided into a plurality of first sections 40 which are arranged in a column extending in the Y direction on the epitaxial crystalline second regions 21 and which are spaced apart from one another by the electrically inactive third regions 34. The sections 40 of the first power electrode 17 are arranged on the epitaxially crystalline second regions 21 so that a plurality of first power finger sections 40 is arranged in a column extending in the Y direction. Similarly, the second power finger 18 also comprises a plurality of sections 41 which are positioned on the second regions 21. One section 40 of the first power finger 17 is aligned in the X direction with one section 41 of the second power finger 41. The one section 40 of the first power finger 17 is arranged on the same second section 21 as the one section 41 of the second power finger 41.

The gate finger 19 extends continuously over the second and third regions 21, 34. The common gate finger 19 is arranged laterally between the columns of the first finger portions 40 and second power finger portion sections 41.

A first metal power finger 17 extends parallel to the gate finger 19 and electrically connects the first power finger sections 40 to one another. Similarly, a second metal power finger 18 extends parallel to the gate finger 19 and electrically connects the second power finger sections 41 to one another. The first and second metal power fingers 17, 18 extend over the third regions 34 and second regions 21 and electrically connects the transistor sections formed on the second regions 21 and the transistor sections formed in the first regions 20 in parallel.

The semiconductor device of any one of the embodiments described with reference to figures 1 to 5 may be configured as a transistor device or as a bidirectional switch. If the semiconductor device 10 is configured as a transistor device, the first power finger 17 may provide the source finger and the second power finger 18 provide the drain finger of the transistor device structure. If the semiconductor device 10 is configured as a bidirectional switch, the first power finger 17 may provide the first input/output finger and the second power finger 18 provide the second input/output finger of the bidirectional switch structure.

As discussed above, the presence of the trap-rich first regions 20 has the effect of lowering the breakdown voltage of the transistor device or bidirectional switch. This effect may be used to fabricate devices in a common substrate which have differing threshold voltages by selectively implanting species into at least regions of the one or more semiconductor devices, or into a region in which a semiconductor device is to be formed which are to have a lower threshold voltage. The one or more semiconductor devices which are to have a higher threshold voltage, or the region of the die 50 in which one or more semiconductor devices having a higher threshold voltage are to be formed, are not additionally implanted.

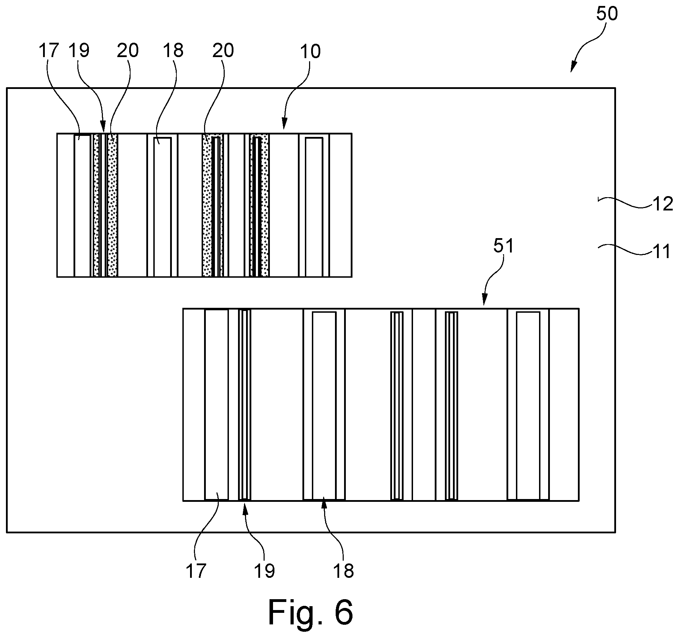

Figure 6 illustrates a Group III nitride die 50 which has first and second devices 10, 51 of differing threshold voltages that are integrated into a common Group III nitride body 11 of the die 50. The Group III nitride die 50 comprises a Group III nitride channel layer 13 and Group III nitride barrier layer 14 as described with reference to figure 1.

The die 50 includes a first transistor device 10 which includes at least one implanted first region 20. The semiconductor device 10 may have the structure of any one of the embodiments described with reference to figures 1 to 5. The Group III nitride die 50 also includes a second transistor device 51. The second transistor device 51 is formed in the same Group III nitride body 11 as the first semiconductor device 10 so that the first semiconductor device 10 and the second transistor device 51 may be considered to be monolithically integrated into a common Group III nitride body 11.

The threshold voltage of the semiconductor device 10 is less than the threshold voltage of the second transistor device 51. This reduction in the threshold voltage of the semiconductor device 10 is achieved by selectively implanting species into one or more regions of the Group III nitride body 11 which are located under the gate finger 19 of the semiconductor device 10 to form a trap-rich disturbed crystal structure and the first region 20. The semiconductor device 10, therefore, includes one or more regions 20 having a disturbed crystalline structure, whereas the second transistor device 51 is free of such disturbed crystalline areas.

Since the devices 10, 51 are monolithically integrated into a common Group III nitride body 11, the composition of the Group III nitride barrier layer 14 is substantially uniform in both the semiconductor device 10 and the second transistor device 51.

Since the devices 10, 51 are monolithically integrated into a common Group III nitride body 11, the thickness of the Group III nitride barrier layer 14 is substantially uniform in both the semiconductor device 10 and the second transistor device 51. For example, the thickness of the Group III nitride barrier layer 14 in the region providing the semiconductor device 10 and the second transistor device 51 may have a thickness that ranges from 10 nm ± 8 nm to 15 nm ± 20 nm, for example 20 nm ± 10 nm. For multibarrier devices, the thickness can vary between 20nm ± 15nm below the gate and 80 ± 70nm in the access region, the access region being the region of the Group III nitride body 11 located between the gate finger 19 and the drain finger 18.

In an embodiment, the semiconductor device 10 may be an enhancement mode transistor device or an enhancement mode bidirectional switch. In these embodiments, the gate finger 19 may comprise a p doped Group III nitride finger 25 and a gate metal finger 26 as described with reference to figure 3. In another embodiment, the gate finger 19 has a recessed gate structure to form an enhancement mode device. The second transistor device 31 may be an enhancement mode device or a depletion mode device.

In an embodiment, the semiconductor device 10 and the second transistor device 51 are electrically connected to form a circuit. For example, the semiconductor device 10 may form part of a logic device, for example a gate driver circuit and the second transistor device 51 may form part of a power switching circuit, such as half bridge circuit.

In some embodiments two or more second transistor devices 51 are formed in the Group III nitride body 11 and connected so as to form half bridge circuit or bridge circuit for example. The semiconductor device 10 may form part of a gate driver circuit which is connected to the gates of the two or more power transistor devices 51 so as to switch the two or more transistor devices 51.

To summarise, a power transistor device with integrated driver logic can be provided in which Group III nitride transistors, HEMTs, with different threshold voltages (Vth) are integrated within a common Group III nitride substrate, e.g. die. The power transistor 51 has a higher Vth than the driver logic transistor(s) 10. During power ON, the logic transistors 10 with the lower Vth can work earlier than the power transistor(s) 51 so that an uncontrolled turn on of the power HEMT 51 can be avoided.

Although the present disclosure is not so limited, the following numbered examples demonstrate one or more aspects of the disclosure.

### Examples

1. A semiconductor device, comprising:
   an epitaxial crystalline Group III nitride body comprising a first major surface, a Group III nitride channel layer and a Group III nitride barrier layer arranged on the Group III nitride channel layer and forming a heterojunction therebetween capable of supporting a two-dimensional charge gas,
   a first power finger, a second power finger and a gate finger located on the first major surface, wherein the gate finger is located between the first and second power fingers,
   wherein at least one first region of the Group III nitride body that is located under the gate finger comprises a trap-rich crystal structure.
2. The semiconductor device according to example 1, wherein trap rich crystal structure comprises one or more of the group consisting of
   a disturbed crystal structure comprising at least one of group consisting of vacancies, interstitial N atoms and interstitial Group III atoms, dopants of a second conductivity type that opposes a first conductivity type of the Group III nitride body, a concentration of dopants of the same conductivity type as the conductivity type of the Group III nitride body that is higher than in regions of the Group III nitride body that are adjacent to the at least one first region, an electrically inactive region, and an amorphous structure.
3. The semiconductor device according to example 1 or example 2, wherein at least one first region of the transistor device comprises a lower threshold voltage than a threshold voltage of an adjoining second region of the transistor device.
4. The semiconductor device according to any one of examples 3, wherein the first region is contiguous with the second region.
5. The semiconductor device according to any one of examples 1 to 4, wherein the first region is located at a transition region between an active region and an edge region of the semiconductor device.
6. The semiconductor device according to any one of examples 1 to 5, wherein a plurality of first regions is spaced at intervals along the length of the gate finger.
7. The semiconductor device according to any one of examples 1 to 6, wherein at least one second region of the Group III nitride body that is located under the gate finger comprises an epitaxial crystal structure.
8. The semiconductor device according to any one of examples 1 to 7, further comprising at least one third region located intermediate the length of the gate finger, wherein the third region comprises an electrically inactive region or a recess.
9. The semiconductor device according to example 8, wherein the first region is contiguous with the third region and with the second region.
10. The semiconductor device according to any one of examples 1 to 9, wherein the semiconductor device comprises a plurality of transistor device structures formed between the first and second power fingers, wherein the plurality of transistor device structures are connected in parallel.
11. The semiconductor device according to any one of examples 1 to 10, wherein the Group III nitride body comprises an active area and an edge region that laterally surrounds the active area and the edge region comprises an electrically inactive region.
12. The semiconductor device according to any one of example 11, wherein the first power finger, the second power finger and the gate finger are positioned on the active area.
13. The semiconductor device according to example 11 or example 12, wherein at least one of the first regions is contiguous with the edge region.
14. The semiconductor device according to any one of examples 1 to 13, further comprising a base substrate with a growth surface which is capable of supporting the epitaxial growth of at least one Group III nitride layer and a Group III nitride buffer layer on the growth surface, wherein the channel layer is arranged on the Group III nitride buffer layer, wherein the trap-rich crystal structure of the at least one first region extends from the first major surface, through the Group III nitride barrier layer and into the Group III nitride channel layer.
15. The semiconductor device according to any one of examples 1 to 14, wherein the gate finger comprises a p-doped Group III nitride layer on the first major surface and a gate metal layer arranged on the p-doped Group III nitride layer and the at least one first region with the trap-rich crystal structure is located in the p-doped Group III nitride finger and extends through the Group III nitride barrier layer and into the Group III nitride channel layer.
16. A Group III nitride die, comprising:
   at least one semiconductor device according to any one of examples 1 to 15 located in the Group III nitride body and configured as first transistor device or configured as a bidirectional switch;
   a second transistor device that is located in the Group III nitride body,
   wherein the second transistor device has a higher threshold voltage than a threshold voltage of the at least one first transistor device, or a higher threshold voltage that a threshold voltage of the at least one bidirectional switch.
17. The Group III nitride die according to example 16, wherein the second transistor device is free of trap-rich areas.
18. The Group III nitride die according to example 16 or example 17, wherein the Group III nitride barrier layer of the at least one first transistor device or of the at least one bidirectional switch and of the second transistor device has the same thickness and/or the Group III nitride barrier layer of the at least one first transistor device or of the at least one bidirectional switch and of the second transistor device has the same composition.
19. The Group III nitride die according to example 18, wherein the Group III nitride barrier layer of the at least one first transistor device or of the at least one bidirectional switch and of the second transistor device has an average thickness lying in the range of 10nm ± 8nm to 50nm ± 20nm or around 20nm ± 10nm, or 20nm ± 15nm below the gate and 80 ± 70nm in the access region.
20. The Group III nitride die according to any one of examples 16 to 19, wherein the at least one first transistor device or the at least one bidirectional switch is an enhancement mode device.
21. The Group III nitride die according to any one of examples 16 to 20, wherein the second transistor device is an enhancement mode device or a depletion mode device.
22. The Group III nitride die according to any one of examples 16 to 20, wherein the second transistor device comprises a source terminal, a gate terminal and a drain terminal and is configured to switch a load and the at least one first transistor device is coupled to the gate of the second transistor device.
23. A method of fabricating a Group III nitride device, the method comprising:
   providing an epitaxial crystalline Group III nitride body comprising a first major surface, a Group III nitride channel layer and a Group III nitride barrier layer arranged on the Group III nitride channel layer and forming a heterojunction therebetween capable of supporting a two-dimensional charge gas,
   implanting species into the Group III nitride body and forming at least one first region having a trap-rich crystal structure in the epitaxial crystalline Group III nitride body, or
   implanting species into the Group III nitride body and forming at least one first region having a trap rich crystal structure between an electrically inactive region and an epitaxial crystalline region and thus forming a transition region between the electrically inactive region and the epitaxial crystalline region;
   forming a gate finger on the first major surface that extends over the at least one first region;
   forming a first power finger and a second power finger on the first major surface on opposing sides of the gate finger.
24. The method according to example 23, wherein the at least one first region of the transistor device comprises a lower threshold voltage than an adjoining second region of the transistor device.
25. The method according to example 23 or example 24, further comprising forming a p-doped Group III nitride layer on the first major surface,
   wherein the implanting species into the Group III nitride body further comprises implanting the species into the p-doped Group III nitride layer and forming a trap-rich crystal structure in the p-doped Group III nitride layer,
   wherein the forming the gate finger further comprises:
      structuring the p-doped Group III nitride layer to form at least one p-doped Group III nitride finger and forming a gate metal finger on the p-doped Group III nitride finger.
26. The method according to any one of examples 23 to 25, wherein the forming the gate metal finger comprises: forming a gate metal layer on the p-doped Group III nitride finger and structure the gate metal layer to form the gate metal finger on the p-doped Group III nitride finger.
27. The method according to any one of examples 23 to 26, wherein the implanting species into the Group III nitride body comprises
   implanting the species into a third area that is located intermediate the length of the p-doped Group III nitride finger and forming an electrically inactive structure in a third region of the Group III nitride body under the third area, wherein the trap-rich crystal structure is formed in the first region of the Group III nitride body that is contiguous to the third region.
28. The method according to any one of examples 23 to 27, wherein the species are implanted into the edge region of the Group III nitride body to form an electrically isolated structure in the edge region, wherein at least one first region with a disturbed crystalline structure is formed that is contiguous to the edge region and located under the gate.
29. The method according to example 28, wherein the species are implanted in the third region and the first region is formed contemporaneously with the third region.
30. The method according to any one of examples 23 to 29, wherein the species are implanted contemporaneously in the third region and the edge region and the first region is formed contemporaneously with the third region.
31. The method according to any one of examples 23 to 30, wherein the species are implanted into the first region with a first energy and a first dose to form a disturbed crystal structure from the epitaxial crystalline structure or the doping level is modified in the first region without destroying/disrupting the crystal structure and the species are implanted into the third region to form the electrically inactive structure from the epitaxial crystalline structure.
32. The method according to any one of examples 23 to 31, wherein the species are implanted into the first region with a first energy and a first dose to form the disturbed crystal structure from the epitaxial crystalline structure and into the edge region to form the electrically inactive structure from the epitaxial crystalline structure.
33. The method according to any one of examples 23 to 30, wherein the species are implanted into the first region with a first energy and a first dose to form the disturbed crystal structure from the epitaxial crystalline structure and into the edge region to increase the number of traps in the edge region.
34. The method according to any one of examples 23 to 30, wherein the species are implanted into the first region with a first energy and a first dose to form the disturbed crystal structure from the epitaxial crystalline structure and into the third region to increase the number of traps in the third region.
35. The method according to any one of examples 23 to 34, wherein the species comprise one or more of the group consisting of N, Si, Ar, BF2, B, As and P.

Spatially relative terms such as "under", "below", "lower", "over", "upper" and the like are used for ease of description to explain the positioning of one element relative to a second element. These terms are intended to encompass different orientations of the device in addition to different orientations than those depicted in the figures. Further, terms such as "first", "second", and the like, are also used to describe various elements, regions, sections, etc. and are also not intended to be limiting. Like terms refer to like elements throughout the description.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise. It is to be understood that the features of the various embodiments described herein may be combined with each other, unless specifically noted otherwise.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A semiconductor device, comprising:
an epitaxial crystalline Group III nitride body comprising a first major surface, a Group III nitride channel layer and a Group III nitride barrier layer arranged on the Group III nitride channel layer and forming a heterojunction therebetween capable of supporting a two-dimensional charge gas,
a first power finger, a second power finger and a gate finger located on the first major surface, wherein the gate finger is located between the first and second power fingers,
wherein at least one first region of the Group III nitride body that is located under the gate finger comprises a trap-rich crystal structure.

2. The semiconductor device according to claim 1, wherein at least one first region of the transistor device comprises a lower threshold voltage than a threshold voltage of an adjoining second region of the transistor device.

3. The semiconductor device according to claim 1 or claim 2, wherein a plurality of first regions is spaced at intervals along the length of the gate finger.

4. The semiconductor device according to any one of claims 1 to 3, wherein at least one second region of the Group **III** nitride body that is located under the gate finger comprises an epitaxial crystal structure.

5. The semiconductor device according to any one of claims 1 to 4, further comprising at least one third region located intermediate the length of the gate finger, wherein the third region is electrically inactive.

6. The semiconductor device according to claim 5, wherein the first region is contiguous with the third region.

7. The semiconductor device according to any one of claims 1 to 6, wherein the semiconductor device comprises a plurality of transistor device structures formed between the first and second power fingers, wherein the plurality of transistor device structures are connected in parallel.

8. The semiconductor device according to any one of claims 1 to 7, further comprising a base substrate with a growth surface which is capable of supporting the epitaxial growth of at least one Group III nitride layer and a Group III nitride buffer layer on the growth surface, wherein the channel layer is arranged on the Group III nitride buffer layer, wherein the trap-rich crystal structure of the at least one first region extends from the first major surface, through the Group III nitride barrier layer and into the Group III nitride channel layer.

9. The semiconductor device according to any one of claims 1 to 8, wherein the gate finger comprises a p-doped Group III nitride layer on the first major surface and a gate metal layer arranged on the p-doped Group III nitride layer and the at least one first region with the trap-rich crystal structure or with a differently less p-doped, or an isolated or a n-doped crystal structure is located in the p-doped Group III nitride finger and extends through the Group III nitride barrier layer and into the Group III nitride channel layer.

10. A Group III nitride die, comprising:
at least one semiconductor device according to any one of claims 1 to 9, which is located in the Group III nitride body and configured as first transistor device or configured as a bidirectional switch;
a second transistor device that is located in the Group III nitride body,
wherein the second transistor device has a higher threshold voltage than a threshold voltage of the at least one first transistor device, or a higher threshold voltage that a threshold voltage of the at least one bidirectional switch.

11. The Group III nitride die according to claim 10, wherein the second transistor device comprises a source terminal, a gate terminal and a drain terminal and is configured to switch a load and the at least one first transistor device is coupled to the gate of the second transistor device.

12. A method of fabricating a Group III nitride device, the method comprising:
providing an epitaxial crystalline Group III nitride body comprising a first major surface, a Group III nitride channel layer and a Group III nitride barrier layer arranged on the Group III nitride channel layer and forming a heterojunction therebetween capable of supporting a two-dimensional charge gas,
implanting species into the Group III nitride body and forming at least one first region having a trap-rich crystal structure in the epitaxial crystalline Group III nitride body,
or implanting species into the Group III nitride body and forming at least one first region having a trap rich crystal structure between a damaged region and an undamaged epitaxial crystalline region and thus forming a transition region between the damaged region and the undamaged epitaxial crystalline region;
forming a gate finger on the first major surface that extends over the at least one first region;
forming a first power finger and a second power finger on the first major surface on opposing sides of the gate finger.

13. The method according to claim 12, further comprising forming a p-doped Group III nitride layer on the first major surface,
wherein the implanting species into the Group III nitride body further comprises implanting the species into the p-doped Group III nitride layer and forming a trap-rich crystal structure in the p-doped Group III nitride layer,
wherein the forming the gate finger further comprises:
structuring the p-doped Group III nitride layer to form at least one p-doped Group III nitride finger and forming a gate metal finger on the p-doped Group III nitride finger.

14. The method according to claim 12 or claim 13, wherein the implanting species into the Group III nitride body comprises
implanting the species into a third area that is located intermediate the length of the p-doped Group III nitride finger and forming an electrically inactive structure in a third region of the Group III nitride body under the third area, wherein the trap-rich crystal structure is formed in the first region of the Group III nitride body that is contiguous to the third region.

15. The method according to claim 14, wherein the species are implanted in the third region and the first region is formed contemporaneously with the third region.
